# EUROPEAN PATENT APPLICATION

(11) **EP 3 242 540 A1**
(43) Date of publication of application: **08.11.2017**
(21) Application number: 16168547.4
(22) Date of filing: 06.05.2016
(51) Int. Cl.: H05K 5/02

(54) **HOUSING ARRANGEMENT**

(71) Applicant: Mahle International GmbH, 70376 Stuttgart (DE)
(72) Inventor: FLEITH, Emmanuel, 68320 Holtzwihr (FR); RASSENT, Maxime, 67100 Strasbourg (FR)
(74) Representative: BRP Renaud & Partner mbB Rechtsanwälte Patentanwälte Steuerberater

(57) **Abstract**

The invention relates to a housing arrangement (1),
- having a housing (10) which has a housing wall (11) with an outer side (12) and an inner side (13), an aperture (14) being provided in the housing wall (11),
- having a holding device (2) for an electrical connector, which holding device (2) can be inserted or is inserted partially into the aperture (14), the holding device (2) having a base plate with a first and a second side (4a, 4b), a receiving element (5) with a receiving opening (6) which is preferably slot-like protruding from the first side (4a), into which receiving opening (6) the electrical connector can be inserted or is inserted,
- the holding device (2) comprising a fastening apparatus (7) for fixing the holding device (2) in the aperture (14),
the holding device (2) being configured in such a way that it can be inserted both from the outer side (12) and from the inner side (13) of the housing wall (11) into the aperture (14) and can be fixed in the latter.

## Description

The invention relates to a housing arrangement.

Housings for electric and electronic devices serve to receive said devices in a housing interior space which is delimited by the housing. One or more housing walls of the housing are often used to fasten an electric/electronic control device comprising a heating device releasably to the housing.

It is known from the prior art to arrange a holding device for an electrical connector of the controller including the heating device in an aperture which is provided on the housing wall and to fasten them there releasably. This allows a holding device in the manner of an adapter which is adapted in each case to the geometry and to the external dimensions of the electric connector thereof to be mounted on the housing for different types of control devices.

It proves problematic, however, in conventional housing arrangements of this type with a housing and a holding device which can be attached releasably to the housing that said mounting region of the holding device (typically an aperture which is provided in a housing wall of the housing) is often accessible to a worker only with difficulty. This makes the mounting operation, and therefore also the desired, permanently stable fastening of the holding device in an aperture which is provided in the housing more difficult, to be precise both in the lateral direction and in a direction perpendicularly with respect to the housing wall.

It is therefore an object of the present invention to indicate new approaches in the development of housing arrangements with a housing and a holding device which can be fastened releasably to the housing.

This object is achieved by way of the subject matter of the independent patent claims. Preferred embodiments are the subject matter of the dependent patent claims.

It is accordingly a basic concept to configure a housing arrangement with a housing and a holding device which can be fastened releasably thereto for holding an electrical connector of an electric/electronic controller in such a way that the holding device can be mounted by a worker on the housing both from the inside, that is to say typically from a housing interior space which is delimited by the housing, or from the outside. The worker can therefore choose in a manner which is dependent on the situation which fastening variant can be carried out more simply. In both cases, the holding device is positioned in an aperture which is configured on a housing wall of the housing and is fixed there by means of a fastening apparatus which is provided on the holding device.

A housing arrangement according to the invention comprises a housing which has a housing wall with an outer side and an inner side, an aperture being provided in the housing wall. A holding device for an electrical connector of a controller can be inserted or is inserted at least partially into the aperture. The holding device comprises a base plate with a first and a second side. A receiving element with a slot-like receiving opening protrudes from the first side, into which receiving opening the electrical connector can be inserted or is inserted. The holding device comprises a fastening apparatus for fixing the holding device in the aperture.

According to the invention, the holding device is configured in such a way that it can be inserted into the aperture both from the outer side and from the inner side of the housing wall and can be fixed in the aperture.

According to one preferred embodiment of the invention, the holding device with its base plate is configured in such a way that it can be placed onto the outer side or inner side of the housing wall in the region of the aperture and can be fastened by means of the fastening apparatus by way of subsequent lateral displacement. This measure allows simple and nevertheless stable mechanical fixing of the holding device on the housing.

The holding device which is fixed in the aperture by means of the fastening apparatus expediently either bears with an outer edge section of the second side against the outer side of the housing wall; as an alternative to this, however, the holding device which is fixed in the aperture by means of the fastening apparatus can also bear with an outer edge section of the first side against the inner side of the housing wall. This allows a worker to comfortably mount the holding device on the housing wall both from the inside and from the outside.

The fastening apparatus can particularly expediently be configured in the manner of a bayonet catch. A bayonet catch of this type allows comfortable mounting/dismantling of the holding device by the worker.

In one advantageous development, the fastening apparatus, in particular the bayonet catch, has a plurality of first and second projections which are provided in each case on the first and the second side. In said variant, said projections are configured in such a way that, if the holding device is inserted into the aperture from the outer side of the housing wall, it is fixed in the aperture by means of the second projections. If the holding device is inserted into the aperture from the inner side of the housing wall, in contrast, the holding device is fixed in the aperture by means of the first projections.

In a further preferred embodiment, with regard to a plan view of the first and second side, the first and second projections are arranged at in each case non-identical lateral positions on the first and second side. This measure allows fixing of the holding device by means of the projections both in the case of mounting on the outer side and on the inner side of the housing wall.

A first web is particularly preferably configured on the first side of the base plate. The first projections are formed on said first web. In this variant, a second web, on which the second projections are formed, is configured on the second side of the base plate. Said measure simplifies the configuration of the projections on the base plate, for instance during the production of the holding device by means of a plastic injection moulding process.

With regard to a plan view of the first and second side of the holding device, the first web with the first projections and the second web with the second projections are particularly preferably arranged at in each case non-identical lateral positions on the first and second side. This measure also assists problem-free fixing of the holding device by means of the projections both in the case of mounting on the outer side and on the inner side of the housing wall.

The two webs can expediently be configured in each case as circumferential webs. This permits particularly stable fixing of the base plate in the housing wall in the lateral direction.

In a further preferred embodiment, as viewed in the plan view of the first and second side of the holding device, the first and second projections protrude laterally to the outside from the respective circumferential web. This facilitates fixing of the base plate in a direction perpendicularly with respect to the housing wall by way of lateral displacement of the base plate after the positioning in the aperture.

In the plan view, the two webs can expediently in each case have the contour of a rectangle, on the longitudinal sides of which the first and second projections are arranged. Webs having a geometry of this type can be produced particularly simply, which has an advantageous effect on the production costs of the holding device and therefore of the entire device arrangement.

The projections can particularly expediently be arranged symmetrically on end sections of the longitudinal sides, which end sections face the transverse sides of the rectangle.

A further, particularly preferred embodiment, in which in each case four first and second projections are provided, proves particularly advantageous because it makes particularly stable fastening of the holding device to the base plate possible.

Stable lateral fastening of the holding device to the housing wall can also be achieved if at least one clip element is provided on a circumferential side of the base plate, which clip element interacts with at least one complementary latching lug which is provided on the outer side and/or on the inner side of the housing wall in order to form a latching connection.

The holding device can be mounted on the housing in a particularly comfortable manner in a further preferred embodiment, in which the holding device with its base plate is configured in such a way that it can be placed onto the outer side or inner side of the housing wall in the region of the aperture and can be fixed by means of the fastening apparatus by way of subsequent lateral displacement.

Particularly stable fixing of the holding device on the housing can be achieved if the base plate bears with an outer edge section against the outer or inner side of the housing wall in a state, in which it is fastened to the housing wall.

Further important features and advantages of the invention arise from the subclaims, from the drawing and from the associated description of the figures using the drawing.

It goes without saying that the features which are mentioned in the above text and are still to be explained in the following text can be used not only in the respectively specified combination, but rather also in other combinations or on their own, without departing from the scope of the present invention.

Preferred exemplary embodiments of the invention are shown in the drawings and will be explained in greater detail in the following description, identical designations relating to identical or similar or functionally identical components.

In the drawings, in each case diagrammatically:
- figs. 1 and 2: show the holding device of the housing arrangement in a perspective illustration,
- figs. 3 and 4: show the holding device of figures 1 and 2 in the case of mounting on the housing from the outside,
- figs. 5 and 6: show detailed illustrations of figure 4 in the region of a clip element which is configured on the holding device,
- fig. 7: shows the holding device of figures 1 and 2 in the case of mounting on the housing from the inside, and
- fig. 8: shows a detailed illustration of figure 7 in the region of the clip element which is configured on the holding device.

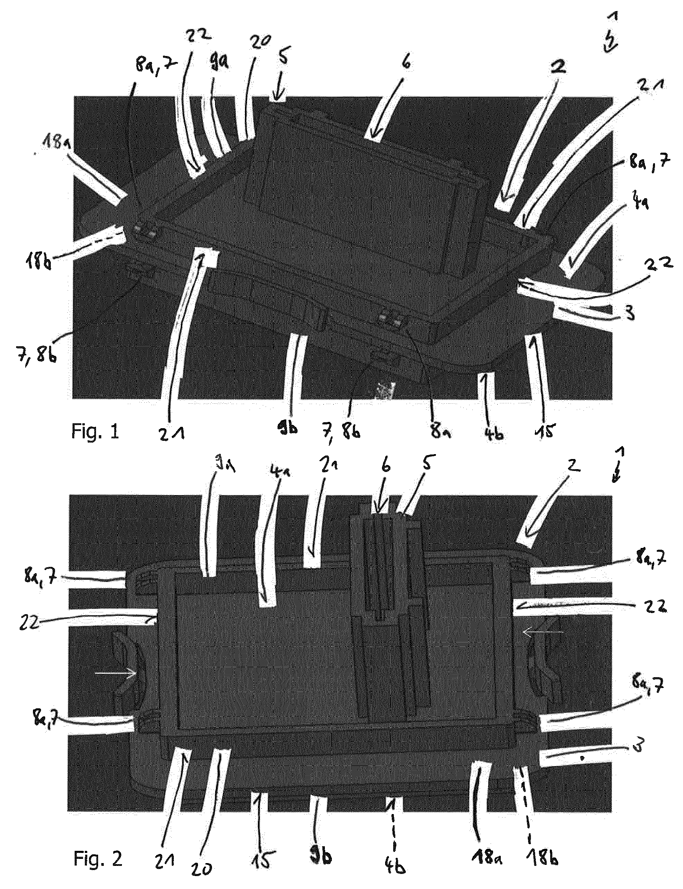

Figures 1 and 2 show different perspective views of a holding device 2 of a housing arrangement 1 according to the invention. The holding device 2 serves to hold or receive an electrical connector of a blower controller comprising a heater for cooling measurements (not shown in greater detail in the figures).

According to figures 1 and 2, the holding device 2 comprises a base plate 3 with a first and a second side 4a, 4b. A receiving element 5 with a slot-like receiving opening 6 protrudes from the first side 4a, into which receiving opening 6 an electrical connector of the blower controller can be inserted. The receiving element 5 can be formed integrally on the base plate 3. This is suitable, in particular, if the holding device 2 is a plastic injection moulded part.

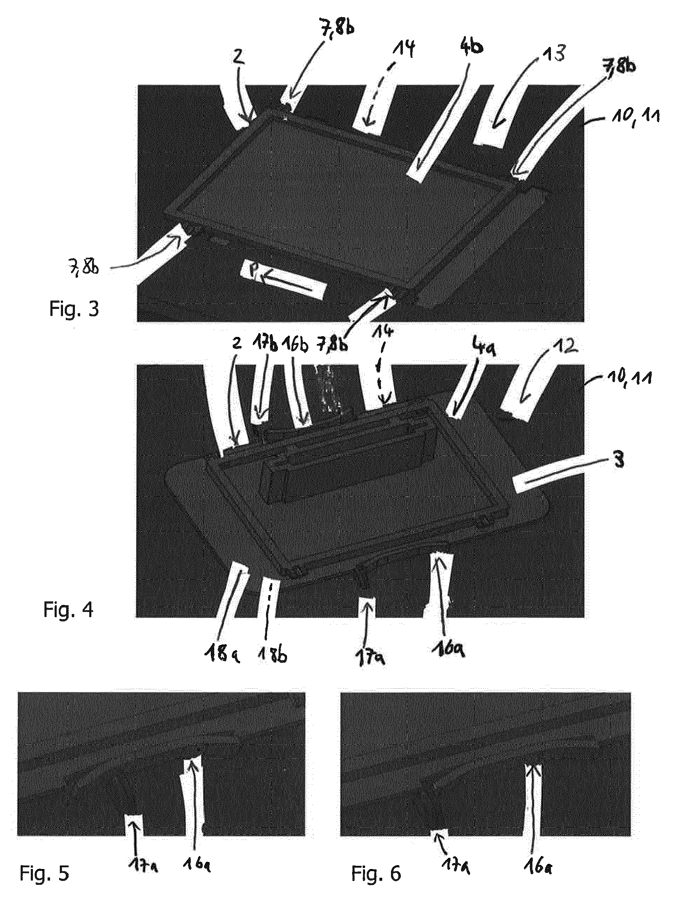

Furthermore, the holding device 2 comprises a fastening apparatus 7, by means of which the holding device 2 can be fastened to a housing. Figures 3 and 4 show this scenario, in which a housing wall 11 of a housing 10 of this type is shown in a plan view of an outer side 12 (figure 3) and inner side 13 (figure 4). There is an aperture 14 in the housing wall 11, in which aperture 14 the holding device 2 can be received.

Figures 3 and 4 show the holding device 2 in a state of this type, in which it is received in the aperture 14. Here, the holding device 2 is configured in such a way that it can be inserted into the aperture 14 optionally from the outer side 12 or from the inner side 13 of the housing wall 11, that is to say from both sides 12, 13, and can be fixed on the housing wall 10 in said aperture 14. Here, figures 3 and 4 show the holding device 2 when it is arranged and fixed in the aperture 14 from the outer side 12.

First of all, however, attention is again directed to the illustrations of figures 1 and 2 which show the holding device 2 in a separate illustration. Using figures 1 and 2, the fastening apparatus 7 of the holding device 2 which can be configured as a bayonet catch is first of all to be explained more precisely. The fastening apparatus 7 has a plurality of first projections 8a and second projections 8b which are provided in each case on the first side 4a and on the second side 4b.

The first projections 8a and the second projections 8b are configured in such a way that, if the holding device 2 is inserted into the aperture 14 from the outer side 12 of the housing wall 11 (cf. figure 4), it is fixed in the aperture 14 by means of the second projections 8b (cf. figure 3). It is gathered from figures 3 and 4 that the holding device 2 with its base plate 3 is realized in such a way that it can be placed onto the outer side 12 of the housing wall 11 in the region of the aperture 14 and is fixed in the aperture 14 by means of the fastening apparatus 7 by way of subsequent lateral displacement (cf. arrow P in figure 3). The holding device 2 which is fixed in the aperture 14 by means of the fastening apparatus 7 in this way bears with an outer edge section 18b of the second side 4b of the base plate 3 against the outer side 12 of the housing wall 2. Here, the second projections 8b act in the manner of a bayonet catch and prevent a movement of the holding device 2 in a direction transversely with respect to the lateral plane of the housing wall 11 and therefore undesired "falling" of the holding device 2 out of the aperture 14.

With reference now to figures 1 and 2 again, it is to be noted that, with regard to a plan view of the first and second side 4a, 4b of the base plate 3, the first and second projections 8a, 8b of the holding device 2 are arranged at in each case identical lateral positions on the first and second side 4a, 4b of the holding device 2. A first web 9a, on which the first projections are arranged, is configured on the first side 4a of the base plate 3 for the first projections 8a. A second web 9b, on which the second projections 8b are arranged, is formed correspondingly on the second side 4b of the base plate 3. As can be seen from figures 1 and 2, the two webs 9a, 9b are configured as circumferential webs.

Here, the first projections 8a and the second projections 8b protrude to the outside from the first web 9a and from the second web 9b at a spacing from the base plate 2. The spacing is defined to have enough place for the housing thickness but not more to have pressure to guaranty the desired tightness. In the exemplary scenario, there are four first projections 8a and four second projections 8b by way of example.

In order to ensure that the holding device 2 can be inserted into the aperture 14 both from the outer side 12 and from the inner side 13 of the housing wall 11, with regard to a plan view of the first and second side 4a, 4b of the base plate 3, the first and the second projections 8a, 8b and the first web 9a and the second web 9b are arranged at in each case identical lateral positions on the first and second side 4a, 4b of the base plate 3. In the plan view of the first side 4a and of the second side 4b of the base plate 3, the two webs 9a, 9b preferably in each case have the contour of a rectangle 20, on the longitudinal sides 21 of which the first and second projections 8a, 8b are arranged. Here, the first and second projections 8a, 8b are arranged symmetrically on end sections 23 of the longitudinal sides 21, which end sections 23 face the transverse sides 22 of the rectangle.

As figure 4 clearly illustrates, two clip elements 16a, 16b which lie opposite one another can be configured on a circumferential side 15 of the base plate 3 of the holding device 2. The two clip elements 16a, 16b interact with two complementary latching lugs 17a, 17b which are provided on the outer side 12 of the housing wall 11 (in one variant, they can also be configured on the inner side 13) in order to form a latching connection. Only one of two latching lugs 17a, 17bj[m1] is used at the same time. The choice depends of the free place around the feature.

The clip elements 16a, 16b can be latched to the two latching lugs 17a, 17b by way of the lateral movement of the base plate 3 which is arranged in the aperture 14. In addition to the first and second projections 8a, 8b which ensure fixing of the base plate 3 and therefore of the entire holding device 2 in a direction perpendicularly with respect to the plane of the housing wall 11, this also ensures fixing of the base plate 2 and therefore the entire holding device 3 in the lateral direction, that is to say in the plane of the housing wall 11. Figure 5 shows the clip element 16a before latching to the latching lug 17a; figure 6 shows it in a latched state.

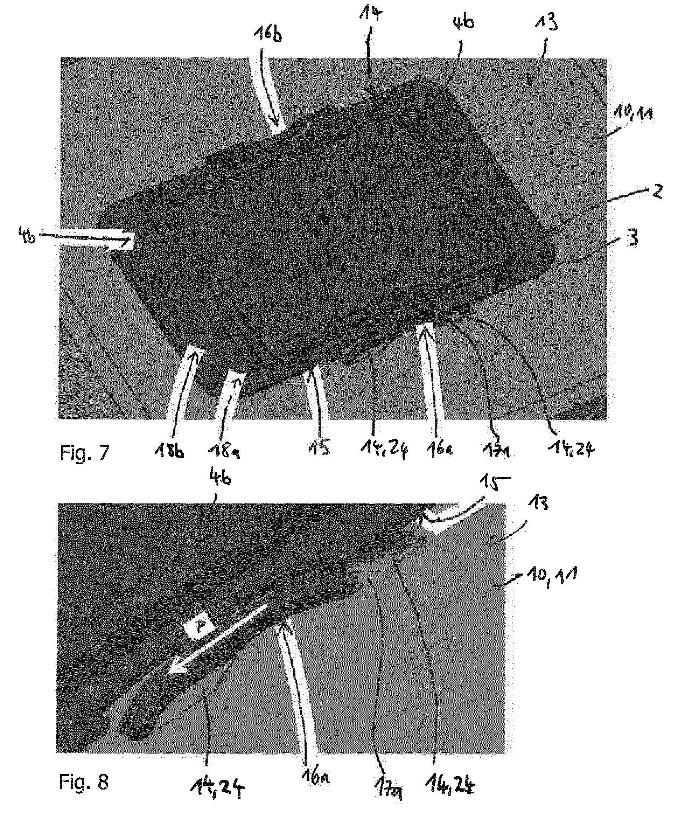

Figure 7 shows a scenario, in which the holding device 2 is inserted into the aperture 14 from the inner side 13 of the housing wall 11 and is fixed in said aperture 14. For fastening to the housing wall 11, the holding device 2 with its base plate 3 is placed onto the inner side 13 of the housing wall 11 in the region of the aperture 14 and is fixed on the housing wall 11 by means of the fastening apparatus 7 by way of subsequent lateral displacement. The holding device 2 which is fixed in the aperture 14 by means of the fastening apparatus 7 bears with an outer edge section 18a of the first side 4a against the inner side 13 of the housing wall 11.

Figure 8 is a detailed illustration of figure 7 in the region of the clip element 16a of the holding device 2. It can be seen that the aperture 14 can have an extension 24 which forms the latching lug 17a on the housing wall 11, which latching lug 17a results in said latching connection in interaction with the clip element 16a. By way of the lateral movement of the base plate 3 which is arranged in the aperture 14 in the direction of the arrow P, the clip element 16a can be latched to the latching lug 17a which is formed by the extension 24 of the aperture 14, as shown in figure 7.

## Claims

1. Housing arrangement (1),
- having a housing (10) which has a housing wall (11) with an outer side (12) and an inner side (13), an aperture (14) being provided in the housing wall (11),
- having a holding device (2) for an electrical connector of a electric/electronic device, which holding device (2) can be inserted or is inserted partially into the aperture (14), the holding device (2) having a base plate with a first and a second side (4a, 4b), a receiving element (5) with a receiving opening (6) which is preferably slot-like protruding from the first side (4a), into which receiving opening (6) the electrical connector can be inserted or is inserted,
- the holding device (2) comprising a fastening apparatus (7) for fixing the holding device (2) in the aperture (14),
the holding device (2) being configured in such a way that it can be inserted both from the outer side (12) and from the inner side (13) of the housing wall (11) into the aperture (14) and can be fixed in the latter.

2. Housing arrangement according to Claim 1,
**characterized in that**
the holding device (2) with its base plate (3) is configured in such a way that it can be placed onto the outer side (12) or inner side (13) of the housing wall (11) in the region of the aperture (14) and can be fastened by means of the fastening apparatus by way of subsequent lateral displacement.

3. Housing arrangement according to Claim 1 or 2,
**characterized in that**
the holding device (2) which is fixed in the aperture (14) by means of the fastening apparatus (6) either bears with an outer edge section of the second side (4b) against the outer side (12) of the housing wall (11) or bears with an outer edge section (18) of the first side (4a) against the inner side (13) of the housing wall (11).

4. Housing arrangement according to one of Claims 1 to 3,
**characterized in that**
the fastening apparatus (7) is configured as a bayonet catch.

5. Housing arrangement according to one of the preceding claims,
**characterized in that**
the fastening apparatus (7), in particular the bayonet catch, has a plurality of first and second projections (8a, 8b) which are provided in each case on the first and the second side (4a, 4b), configured in such a way that, if the holding device (2) is inserted into the aperture (14) from the outer side of the housing wall (11), the holding device (2) is fixed in the aperture (14) by means of the second projections (8b) and, if the holding device (2) is inserted into the aperture (14) from the inner side of the housing wall (11), is fixed in the aperture (14) by means of the first projections (8a).

6. Housing arrangement according to Claim 5,
**characterized in that**,
with regard to a plan view of the first and second side (4a, 4b), the first and second projections (8a, 8b) are arranged at in each case identical lateral positions on the first and second side (4a, 4b).

7. Housing arrangement according to one of the preceding claims,
**characterized in that**
a first web (9a), on which the first projections (8a) are formed, is configured on the first side (4a) of the base plate (3), and a second web (9b), on which the second projections (8b) are formed, is configured on the second side (4b) of the base plate (3).

8. Housing arrangement according to Claim 7,
**characterized in that**,
with regard to a plan view of the first and second side (4a, 4b), the first web (9a) with the first projections (8a) and the second web (9b) with the second projections (8b) are arranged at in each case identical lateral positions on the first and second side (4a, 4b).

9. Housing arrangement according to Claim 7 or 8,
**characterized in that**
the two webs (9a, 9b) are configured as circumferential webs.

10. Housing arrangement according to one of Claims 7 to 9,
**characterized in that**,
as viewed in the plan view of the first and second side (4a, 4b), the first and second projections (8a, 8b) protrude in each case to the outside from the first and second web (9a, 9b).

11. Housing arrangement according to one of Claims 7 to 10,
**characterized in that**,
in the plan view, the two webs (9a, 9b) in each case have the contour of a rectangle (20), on the longitudinal sides (21) of which the first and second projections (8a, 8b) are arranged.

12. Housing arrangement according to Claim 11,
**characterized in that**
the first and second projections (8a, 8b) are arranged symmetrically on end sections (23) of the longitudinal sides (21) of the rectangle (20), which end sections (23) face the transverse sides (22) of the rectangle (20).

13. Housing arrangement according to one of Claims 5 to 12,
**characterized in that**
in each case four first and second projections (8a, 8b) are provided.

14. Housing arrangement according to one of the preceding claims,
**characterized in that**
at least one clip element is configured on a circumferential side (15) of the base plate (3), which clip element interacts with at least one complementary latching lug (17a, 17b) which is provided on the outer side (12) and/or on the inner side (13) of the housing wall (11) in order to form a latching connection.
